# EUROPEAN PATENT APPLICATION

(11) **EP 0 679 914 A1**
(43) Date of publication of application: **02.11.1995**
(21) Application number: 94200536.4
(22) Date of filing: 03.03.1994
(51) Int. Cl.: G02B 6/36, H05K 7/06

(54) **Method of manufacturing a circuit board and circuit board manufactured using this method**

(71) Applicant: ALCATEL BELL Naamloze Vennootschap, B-2018 Antwerpen 1 (BE)
(72) Inventor: Vetter, Peter, B-2000 Antwerp (BE); Delbare, Wim Jozef Robert, B-9080 Beervelde (BE)

(57) **Abstract**

The circuit board includes a board (B) and at least one conductor (F) affixed to a surface of that board by means of a layer of contact glue like adhesive which is operative in a room environment, i.e. no activation of the adhesive is required. The adhesive layer can be realized by means of a two side adhesive tape (T) of which one side is affixed to the base (B) and to the other side of which the conductor (F) is affixed.

## Description

The present invention relates to a method of manufacturing a circuit board which includes a board and at least one signal conductor affixed to a surface of said board, said method including the steps of applying an adhesive layer to said surface and affixing said signal conductor to said adhesive layer.

Such a method is already known in the art, e.g. from the United States Patent 3,674,914. Therein, the conductor is affixed to the board, more specifically to an insulating planar base, by means of an adhesive coating on the surface of the planar base. The adhesive coating is activated chemically or by other means such as pressure, heat or other forms of wave or radiation energy such as light, sound or the like to adherently receive and fix the conductor thereon.

An object of the present invention is to provide a method of the above known type but wherein there is no need for activation of an adhesive.

According to the invention, this object is achieved due to the fact that said adhesive layer is a layer of contact glue like adhesive which is operative in a room environment.

An additional advantage of using a contact glue like adhesive which is active in normal room environment as in the method of the invention is that, especially in the case of an optical fiber conductor, the possibility of damaging that conductor is considerably reduced. Indeed, in the known methods the conductor may be damaged by the activation of the adhesive coating, e.g. by the heating at high temperature of the fiber conductor together with the coating or by exerting pressure on the conductor or by applying ultrasonic energy to the conductor.

An additional feature of the method according to the invention is that said adhesive layer is constituted by a two side adhesive tape which is applied to said surface by mutually affixing one side of said adhesive tape and said surface, said signal conductor being affixed to said adhesive layer by mutually affixing said conductor and the other side of said two side adhesive tape.

Since such a two side adhesive tape or film is commercially available, the adhesive layer can be applied to the surface of the board in a simple way, thereby simplifying the process of applying the adhesive and requiring less complex equipment.

In order to avoid possible shifting of the affixed conductor, said method further includes the step of applying a lamination layer on top of said adhesive layer to which said signal conductor is affixed.

The invention also relates to a circuit board including a board, an adhesive layer applied to a surface of said board and at least one signal conductor affixed to said adhesive layer, such as the circuit board described in the above mentioned US patent. The realization of such a circuit board as described in the latter patent has the earlier mentioned drawbacks with respect to the activation of the adhesive coating.

In order to overcome these drawbacks, a circuit board is realized according to the present invention wherein said adhesive layer is a layer of contact glue like adhesive which is operative in a room environment. As mentioned earlier with respect to the subject method of realizing the circuit board, said adhesive layer can be advantageously constituted by a two side adhesive tape having one side affixed to said surface, said signal conductor being affixed to the other side of said tape. To prevent shifting of the conductor on the adhesive layer, said circuit board additionally includes a lamination layer on top of said adhesive layer to which said conductor is affixed.

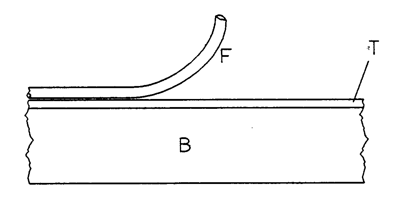

The above mentioned and other objects and features of the invention will become more apparent and the invention itself will be best understood by referring to the following description of an embodiment taken in conjunction with the accompanying drawing which shows an intermediate step in the realization of a circuit board according to the invention.

The drawing shows a base B, more specifically a laminate substrate, of a circuit board upon which a two-side adhesive tape T has been affixed by means of one of its adhesive sides. A fiber conductor F is being laid on the other adhesive side of the tape according to a predetermined pattern.

How the fiber conductor is laid on the adhesive tape is not described in detail and also not shown in the drawing because there exist many known ways to do this. One way is for instance described in the US patent 3,674,914. Mostly use is made of a supply mechanism to supply the fiber conductor and a dispensing head for guiding the fiber conductor to the adhesive surface. Either the dispensing head or a table on which the circuit board is mounted is moved mechanically in such a way that the conductor is affixed to the adhesive tape according to a predetermined pattern. A computerized control mechanism is used to realize the correct movement of the dispensing head and of the table with respect to each other.

Further steps in the realization of the circuit board, such as making via holes and lamination are well known in the art and are therefore not described in detail. These steps are for instance described in the above mentioned US patent.

To be noted that in an alternative way of realizing the subject circuit board the fiber conductor is affixed to the tape before applying the tape to the base. Also the tape can cover the whole surface of the base or can be applied only to those parts of the surface where fiber conductors have to be laid.

Instead of using a two side adhesive tape, a contact glue like fluid can be applied to the surface of the board and be dried so that it gets adhesive properties without needing furter activation such as warming up, radiation and so on.

Contact glue like fluids and tapes or films as described above are commercially available, and are for instance sold by the company 3M.

To be noted also that the base B can be a rigid base, e.g. an epoxy board, as well as a flexible board, e.g. a CAPTON (TM) board from the company Dupont, and that although the above description is made in relation with fiber conductors it is equally applicable to other conductors.

While the principles of the invention have been described above in connection with specific apparatus, it is to be clearly understood that this description is made only by way of example and not as a limitation on the scope of the invention.

## Claims

1. Method of manufacturing a circuit board which includes a board (B) and at least one signal conductor (F) affixed to a surface of said board, said method including the steps of applying an adhesive layer to said surface and affixing said signal conductor to said adhesive layer, characterized in that said adhesive layer is a layer of contact glue like adhesive which is operative in a room environment.

2. Method of manufacturing a circuit board according to claim 1, characterized in that said adhesive layer is constituted by a two side adhesive tape which is applied to said surface by mutually affixing one side of said adhesive tape and said surface, said signal conductor being affixed to said adhesive layer by mutually affixing said conductor and the other side of said two side adhesive tape.

3. Method according to claim 1, characterized in that said signal conductor (F) is an optical fiber conductor.

4. Method according to claim 2, characterized in that one side of said tape and said surface are mutually affixed prior to said signal conductor and said other side of said tape or film being mutually affixed.

5. Method according to claim 2, characterized in that said signal conductor and said other side of said tape or film are mutually affixed prior to said one side of said tape or film and said surface being mutually affixed.

6. Method according to claim 2, characterized in that said method further includes the step of applying a lamination layer on top of said adhesive layer to which said signal conductor (F) is affixed.

7. Circuit board including a board (B), an adhesive layer (T) applied to a surface of said board and at least one signal conductor (F) affixed to said adhesive layer, characterized in that said adhesive layer (T) is a layer of contact glue like adhesive which is operative in a room environment.

8. Circuit board according to claim 7, characterized in that said adhesive layer (T) is constituted by a two side adhesive tape having one side affixed to said surface, said signal conductor (F) being affixed to the other side of said tape.

9. Circuit board according to claim 7, characterized in that said signel conductor (F) is an optical fiber conductor.

10. Circuit board according to claim 7, characterized in that said circuit board additionally includes a lamination layer on top of said adhesive layer to which said conductor is affixed.
